Europäisches Patentamt

European Patent Office

Office européen des brevets

(11) Publication number: **0 343 633**
**A2**

## (12) EUROPEAN PATENT APPLICATION

(21) Application number: **89109390.8**

(22) Date of filing: **24.05.89**

(51) Int. Cl.⁴: **H01L 23/50**

(30) Priority: **24.05.88 JP 126514/88**
**23.12.88 JP 324955/88**

(43) Date of publication of application:
**29.11.89 Bulletin 89/48**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

Applicant: **TOSHIBA MICRO-ELECTRONICS**
**CORPORATION**
**25-1, Ekimaehoncho**
**Kawasaki-ku Kawasaki-shi(JP)**

(72) Inventor: **Asano, Masamichi Intellectual**
**Property Div.**
**K.K. Toshiba 1-1 Shibaura 1-chome**
**Minato-ku Tokyo 105(JP)**
Inventor: **Kobayashi, Kiyoshi Intellectual**
**Property Div.**
**K.K. Toshiba 1-1 Shibaura 1-chome**
**Minato-ku Tokyo 105(JP)**
Inventor: **Iwahashi, Hiroshi Intellectual**
**Property Div.**
**K.K. Toshiba 1-1 Shibaura 1-chome**
**Minato-ku Tokyo 105(JP)**
Inventor: **Kishi, Hiroaki Intellectual Property**
**Div.**
**K.K. Toshiba 1-1 Shibaura 1-chome**
**Minato-ku Tokyo 105(JP)**

(74) Representative: **Ritter und Edler von Fischern,**
**Bernhard,Dipl.-Ing. et al**
**HOFFMANN - EITLE & PARTNER**
**Arabellastrasse 4**
**D-8000 München 81(DE)**

(54) Semiconductor integrated circuit.

(57) A lead frame for supplying a power voltage to a semiconductor chip (31) forks two inner leads (32A, 32B). These inner leads are electrically connected to pad electrodes (20, 21) on the chip (31) by means of bonding wires (33).

F I G. 6

## Semiconductor integrated circuit

The present invention relates to a semiconductor integrated circuit with lessened adverse effects by a power noise due to an overcurrent.

An integrated circuit with a single or a plurality of functions in which a great number of semiconductor elements are integrated into a single chip, is well known as a called IC. The IC chip is housed in a cavity for protecting it from deteriorating and deleterious effects by the surrounding atmosphere. The semiconductor chip contains many pad electrodes for signal transfers and power supplies.

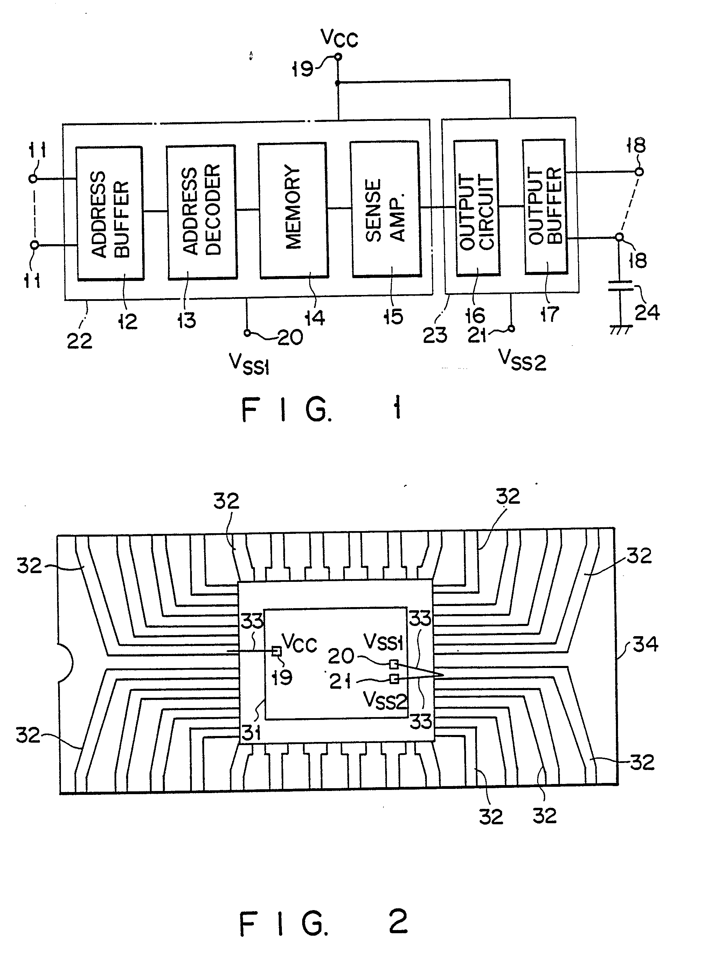

Fig. 1 illustrates a block diagram of a typical circuit contained in a memory IC chip. Address signals applied from exterior to the memory circuit first reach pad electrodes 11, ..., 11 of the memory circuit. The address signals are then inputted to an address buffer circuit 12 and to an address decoder circuit 13. By decode signals outputted from the address decoder circuit 13, data of a plurality of bits are read out of a memory 14, and amplified by a sense amplifier circuit 15. The amplified data signals are applied to an output circuit 16 and subsequently to an output buffer circuit 17. The data signals loaded in the output buffer circuit 17 is outputted outside through pad electrodes 18, ..., 18.

To operate the memory IC chip, power and ground voltages must be supplied thereto from exterior. A power voltage Vcc is applied to a power pad electrode 19. Two ground voltages Vss1 and Vss2 are respectively applied to pads 20 and 21 exclusively used for ground voltage application. Pad electrodes 18, ..., 18 for data outputting contain parasitic capacitances that are treated as a load capacitor 24.

The power voltage Vcc applied to the pad electrode 19 is supplied to an internal circuit 22 and a peripheral circuit 23. The internal circuit 22 is made up of the address buffer 12, address decoder 13, memory 14 and sense amplifier circuit 15. The peripheral circuit 23 is made up of the output circuit 16 and the output buffer circuit 17. Of the two types of ground voltages Vss1 and Vss2, the ground voltage Vss1 is applied to the internal circuit 22. The ground voltage Vss2 is applied to the peripheral circuit 23. The reason why two different ground voltages are applied to those circuits will be described below.

There are many types of memory ICs. Static RAMs and ROMs as typical memory ICs generally use multi-bit of 8 bits or 16 bits, for example, for the output data. The load capacitor 24 parasitic on the pad electrodes for outputting the multibit data is usually about 100 pF. In the memory handling the multibit data, it is required to simultaneously charge and discharge of a plurality of load capacitors. At this time, large currents caused by the charge discharge flow through the power interconnections in the chip. Particularly for the ground voltage interconnections that is long in length and high in line resistance and inductance, the flowing of large current therethrough results in a great variation of the ground voltages. By taking the above fact into account, the ground voltage Vss1 is applied to the internal circuit 22, and another ground voltage Vss2 to the peripheral circuit 23 containing the output buffer through which a large current possibly flows. With such ground voltage supplies, even when noise is generated in the ground voltage Vss2, the ground voltage Vss1 is isolated from that noise. In other memory circuits, the ground potential Vss1 is applied to the output circuit 16 as well as the internal circuit 22, and the ground voltage Vss2 is applied to only the output buffer 17.

The IC package is provided with a lead frame containing inner leads and outer lead integral with the inner leads, in addition to the semiconductor chip. Before packaging, the tips or ends of the inner leads are electrically coupled with the pad electrodes by means of metal wires of Au or Aℓ, for example, that are called bonding wires. After those are coupled by the bonding wires, the inner leads, together with the semiconductor chip, are hermetically encapsulated into a cavity, while the outer leads being left outside the cavity. Then, the outer leads are bent and cut as required, and are used as the external terminals of the DIP type.

Fig. 2 shows the innards of a conventional IC package with 28 pins that houses a memory IC chip. A memory IC chip 31 is provided with many pad electrodes including a pad electrode 19 for the power voltage Vcc, and pad electrodes 20 and 21 for the ground voltages Vss1 and Vss2. Reference number 32, ..., 32 designate inner leads on a lead frame; 33 bonding wires; and 34 a cavity. In the illustration, other pad electrodes than those for power voltages and the outer leads on the lead frame are omitted for simplicity.

As illustrated, the ground voltage for use in the circuits handling large currents such as the output buffer is different from the ground voltage for the remaining circuits. The lead frame, however, is common for both the inner and output leads.

In recent high speed memory devices with reduced access times, a variation of the ground voltage which is due to the inductance components of the lead frame for the ground voltage supply, becomes significant. Let us obtain an inductance of the inner lead 32 on the lead frame for ground voltage supply in the structure as shown in Fig. 2. A self-inductance L of the inner lead may be approximated by

$$L = 2\ell \left( \ln \frac{2\ell}{w+t} + 0.5 + 0.224 \frac{w+t}{\ell} \right)$$
(nH)  (1)

where l: Length of the inner lead, w: Width of the same,
t: Thickness of the same.
We have 12.8 nH, when the following specific values are applied to the above formula: 1 = 1.5 cm, w = 0.05 cm, and t = 0.02 cm.

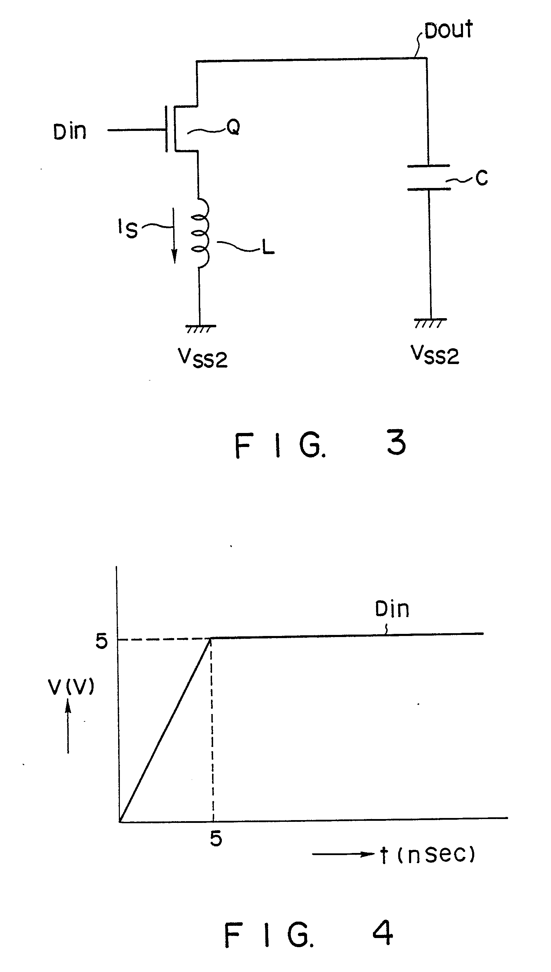

Let us obtain a discharge current of the output buffer in the memory device of Fig. 1. A portion including mainly the output buffer circuit 17 may equivalently be depicted as shown in Fig. 3. In Fig. 3, C represents the load capacitance; Q an n-channel output transistor in the output buffer circuit 17 which is for discharging the load capacitor C; L an self-inductance component existing in the inner lead on the lead frame for the ground voltage supply. The equivalent circuit of Fig. 3 represents the memory device when the discharge of the load capacitor C progresses. In this operation mode, a p-channel output transistor for charging purposes which is connected to a power voltage Vcc in the output buffer is in an off state. Therefore, it is omitted in the illustration. In case that the memory device of the 8-bit type, the capacitance of the load capacitor C is 800 pF because a capacitance for one bit is 100pF, and hence 100pF x 8 = 800pF. Generally, the channel width W and the channel length L of one output transistor are: W = 300μm and L = 2.2μm. The equivalent channel width W and channel length L of the output transistor Q for 8 bits are 2400μm and 2.2μm.

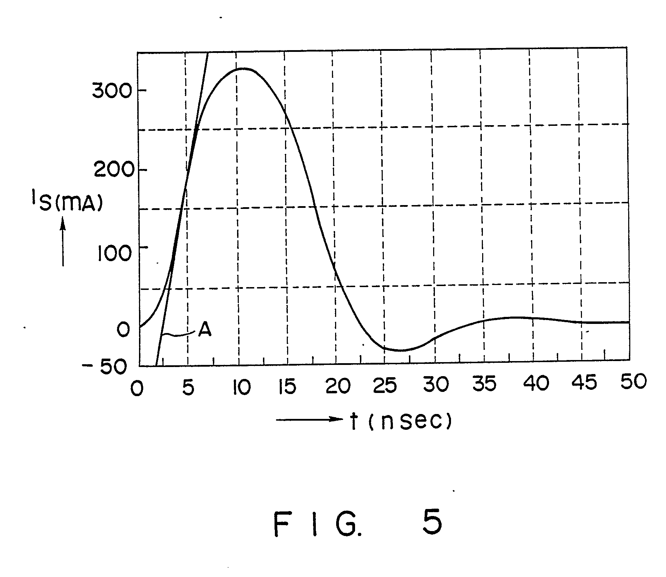

In the above equivalent circuit, a variation of a discharge current Is was simulated by a computer under conditions that the load capacitor C is charged at 5V by a signal Din and a signal Din as shown in Fig. 4 is applied to the gate of the output transistor Q. The variation of the discharge current Is simulated was as shown in Fig. 5. Noise appearing in the ground voltage Vss2 is proportional to a rate of change of the discharge current Is with respect to time "t", viz., dIs/dt. A maximum changing rate of discharge current, i.e., dIs/dt (max), is defined by an inclination of a slanted line A, and approximately 78 x $10^6$ (A/sec). Accordingly, a maximum ground voltage Vss2(max) at the pad electrode 21 when the load capacitor C is discharged is
Vss2(max) = L x dIs/dt(max)  (2)
Substituting the above specific figures, L - 12.8nH and dIs/dt(max) = 78 x $10^6$ A/sec, into the relation (2), we have Vss2(max) = 1V. This shows that in the memory IC shown in Fig. 2, a potential at the pad electrode 21 which should be at 0V, rises up to a maximum of 1V. This great voltage variation at the electrode 21 transfers to the pad electrode 20. Because of this, the internal circuit of the conventional memory IC tends to improperly operate.

Accordingly, an object of the present invention is to provide a semiconductor integrated circuit which minimizes the power noise in the power supply path, thereby almost eliminating the improper operation of the internal circuit.

According to one aspect of the present invention, there is provided a semiconductor integrated circuit comprising: a semiconductor chip having a plurality of pad electrodes on a major surface thereof; a cavity for housing the semiconductor chip; a plurality of lead frames each being made up of an inner lead and an outer lead; metal wires each for electrically connecting the tip of each the inner lead to one pad electrode; and one of the plurality of lead frames whose inner lead has a larger area than those of the other lead frames, the lead frame supplying a power voltage.

According to another aspect of the present invention, there is provided a semiconductor integrated circuit comprising: a semiconductor chip having a plurality of pad electrodes on a major surface thereof; a cavity for housing the semiconductor chip; a plurality of lead frames each being made up of an inner lead and an outer lead, metal wires each for electrically connecting the tip of each the inner lead to one pad electrode; and one of the plurality of lead frames whose inner lead is branched into a plurality of leads, the lead frame supplying a power voltage.

This invention can be more fully understood from the following detailed description when taken in conjunction with the accompanying drawings, in which:

Fig. 1 is a block diagram showing a typical circuit arrangement contained in a conventional memory chip;

Fig. 2 is a plan view showing a pattern in a cavity of a conventional semiconductor IC package;

Fig. 3 is an equivalent circuit diagram of a part of the circuit of Fig. 1;

Fig. 4 shows a waveform of a signal used in the Fig. 3 circuit;

Fig. 5 shows a graphical representation of an electrical characteristic of the Fig. 3 circuit;

Fig. 6 is a plan view showing a pattern within a cavity of a semiconductor integrated circuit according to a first embodiment of the present invention;

Fig. 7 shows a perspective view of the semiconductor IC of Fig. 6;

Fig. 8 is a plan view showing a pattern within a cavity of a semiconductor integrated circuit according to a second embodiment of the present invention;

Fig. 9 is a plan view showing a pattern within a cavity of a semiconductor integrated circuit according to a third embodiment of the present invention;

Fig. 10 is a plan view showing a pattern within a cavity of a semiconductor integrated circuit according to a 4th embodiment of the present invention;

Fig. 11 is a plan view showing a pattern within a cavity of a semiconductor integrated circuit according to a 5th embodiment of the present invention;

Fig. 12 is a plan view showing a pattern within a cavity of a semiconductor integrated circuit according to a 6th embodiment of the present invention;

Fig. 13 is a plan view showing a pattern within a cavity of a semiconductor integrated circuit according to a 7th embodiment of the present invention;

Fig. 14 is a plan view showing a pattern within a cavity of a semiconductor integrated circuit according to an 8th embodiment of the present invention;

Fig. 15 is a plan view showing a pattern within a cavity of a semiconductor integrated circuit according to a 9th embodiment of the present invention; and

Fig. 16 is a plan view showing a pattern within a cavity of a semiconductor integrated circuit according to a 10th embodiment of the present invention.

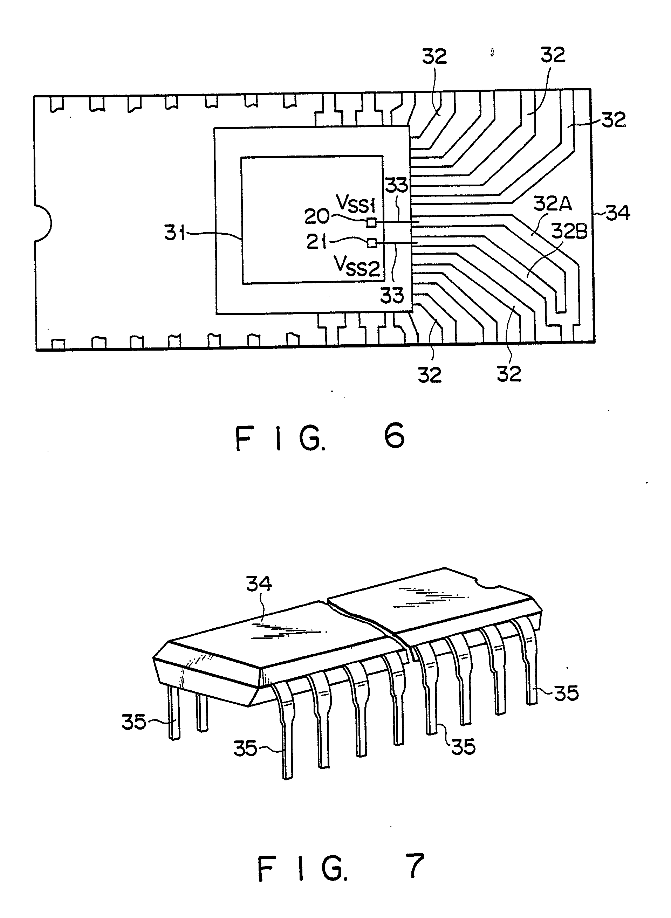

Referring to to Fig. 6, there is shown in a package of a semiconductor integrated circuit according to a first embodiment of the present invention. The integrated circuit (IC) package, like the IC package already described with reference to Fig. 2, uses a memory IC chip 31 with two pad electrodes 20 and 21 for receiving two ground voltages Vss1 and Vss2. In the figure, reference numerals 32 designate inner leads as lead frames; 33 bonding wires; and 34 a cavity. In Fig. 6, the pad electrode for the other power voltage than the ground voltages is omitted as well as the outer leads as the lead frames. In Fig. 7 perspectively showing an appearance of the IC package under discussion, outer leads 35 as lead frames are led out outside the cavity, are properly bent and cut, and are used as external terminals of the dual-in-line (DIP) type.

As best illustrated in Fig. 6, the inner leads 32 for the supply of the ground voltages Vss1 and Vss2 are each branched into two leads 32A and 32B at the portion where is closer to the corner of the cavity 34 and the outer lead 35 (not shown in Fig. 6, but shown in Fig. 7) terminates. Bonding wires 33 electrically connects the tips of the inner leads 32A and 32B to the two pad electrodes 20 and 21 on the chip surface, respectively.

Let us consider a situation that, with the above connections in the semiconductor IC package, a large current flows in a peripheral circuit 23 containing the output buffer 17 (see Fig. 1), and the ground voltage Vss2 at the pad electrode 21 instantaneously rises to approximately 1 V. In this situation, the variation in the ground voltage Vss2 is transferred to the inner lead 32B. It is noted there that the pad electrode 20 coupled with the internal circuit 22 is connected to the outer lead 35 (Fig. 7) through the individual bonding wire 33 and the inner lead 32A which is branched from the inner lead 32A. The connections with the branched inner leads and the individual bonding wire, impedes the transfer of the Vss2 variation on the inner lead 32B to the inner lead 32A connecting to the internal circuit 22. Therefore, the ground voltage Vss2 is stable irrespective of the current variation in the output buffer. The proper operation of the internal circuit 22 is always ensured. The connections using the branched inner leads is advantageous particularly in the recent high speed memory devices, because these require the flow of simultaneous large current into the output buffer. In the high speed memory devices using the above connections, the internal circuit is insensitive to the power noise.

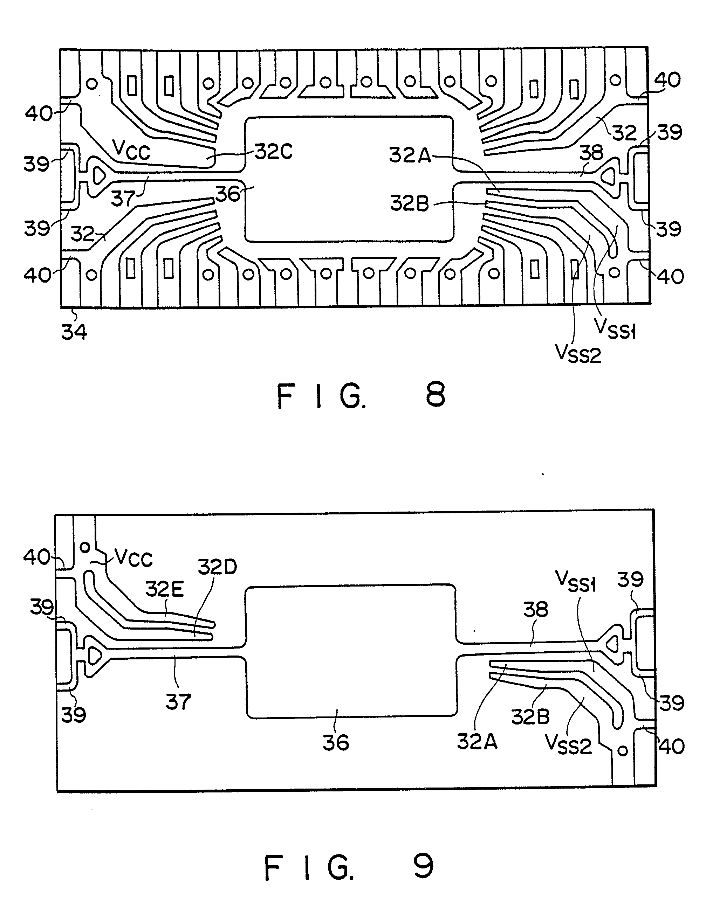

Turning to Fig. 8, there is shown a second embodiment of a semiconductor integrated circuit according to the present invention. The figure shows a pattern inside a cavity 34 which contains lead frames and a bed 36 on which a semiconductor chip is placed. In the figure, pins 37 and 38 are continuous to the bed 36, and for suspending the bed. Supports 39, which are continuous to the suspending pins 37 and 38, fixedly supports these pins.

Also in this embodiment, an inner lead 32 exclusively used for the ground voltage supply forks two parts in the vicinity of a corner of the cavity 34; one part constitutes an inner lead 32A for the ground voltage Vss1 and the other another inner lead 32B for the ground voltage Vss2. An inner lead 32C for the power voltage Vcc has a larger area than each inner lead (not shown) for signal input/output use. Further, in the instant embodiment, pins 40 are provided at the four corners of the cavity 34. These pins 40 fix the inner leads including the inner leads for the power supply that are laid out at the four corners of the cavity, against their displacement from the correct positions, which possibly occurs when the cavity 34 is formed by a resin molding process, e.g., a transfer molding process.

The feature of a large area of the inner lead 32C for the Vcc voltage effectively reduces the power noise generated in the path of the power voltage Vcc. The additional use of the suspending pins 40 reenforces the inner leads and stably positions them in place even if the number and areas of the inner leads increase.

A third embodiment of a semiconductor integrated circuit according to the present invention, is illustrated in Fig. 9. The figure shows inside a cavity 34 a layout of lead frames and a bed 36 on which a semiconductor chip is placed. Also in this embodiment, an inner lead 32 exclusively used for the ground voltage supply forks two parts in the vicinity of a corner of the cavity 34; one part constitutes an inner lead 32A for the ground voltage Vss1 and the other another inner lead 32B for the ground voltage Vss2. An inner lead for the power voltage Vcc is also branched into two inner leads 32D and 32E in the vicinity of a corner of the cavity 34. One or two electrode pads may be used for the Vcc supply. In case that a single electrode pad is used, the branched inner leads 32D and 32E are connected together to the single pad, by means of separate bonding wires. Supports 39 respectively fix suspending pins 37 and 38. Reenforcing pins 40 fix the inner leads including the inner leads for the power supply, that are laid out in the four corners of the cavity 34, against their displacement from the correct positions.

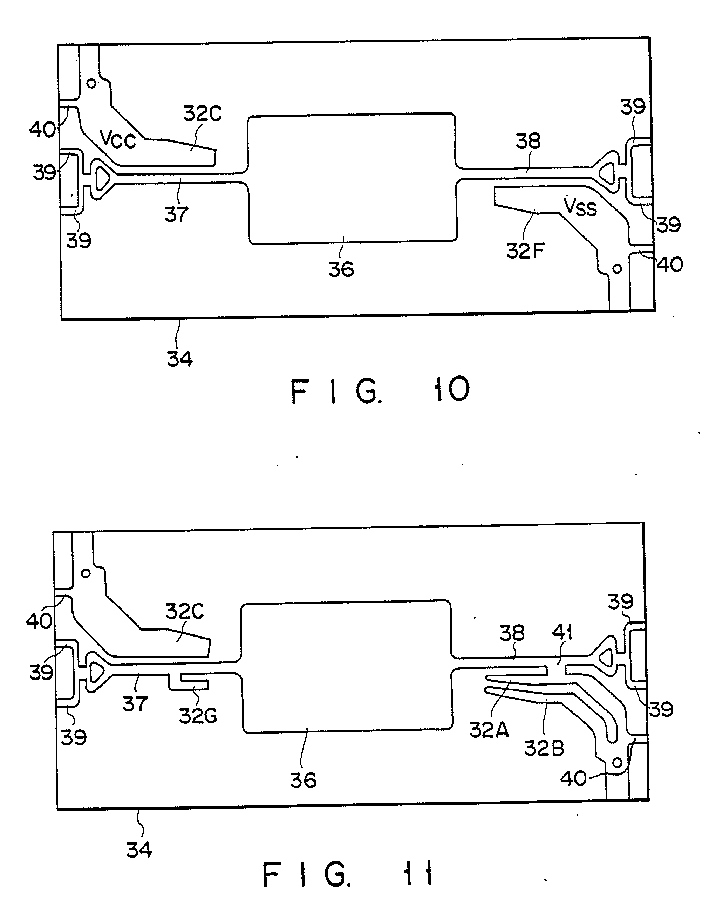

A 4th embodiment of a semiconductor integrated circuit accoridng to the present invention, is illustrated in Fig. 10. The figure shows inside a cavity 34 a layout of lead frames and a bed 36 on which a semiconductor chip is placed. The 4th embodiment is featured in that a single wide inner lead 32F is used for the ground voltage Vss supply, in place of the inner leads 32A and 32B (Fig. 8). An inner lead from the Vcc supply is wider than the other inner leads, as in the second embodiment of Fig. 8.

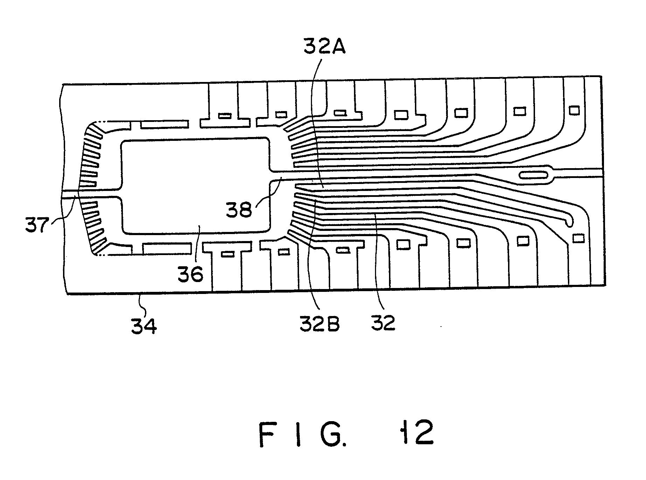

A 5th embodiment of a semiconductor integrated circuit according to the present invention, is illustrated in Fig. 11. The figure shows inside a cavity 34 a layout of lead frames and a bed 36 on which a semiconductor chip is placed. In the 4th embodiment, an inner lead 32A for the Vss1 supply is connected to a suspending pin 38 by a bridge 41. Another inner lead 32G is formed connecting to another suspending pin 37. The ground voltage Vss1 on the inner lead 32A may be led to the additional inner lead 32G, by way of the bridge 41, pin 38, bed 36, and pin 37. Provision of the inner lead 32G allows use of an additional electrode pad for the Vss supply on the semiconductor chip.

A 6th embodiment of a semiconductor integrated circuit according to the present invention, is illustrated in Fig. 12. The figure shows inside a cavity 34 a layout of lead frames and a bed 36 on which a semiconductor chip is placed. In the arrangement that the inner lead for the ground voltage Vss forks two parts, inner leads 32A for Vss1 and 32B for Vss2, as in the Fig. 8 embodiment, the number of inner leads below the suspending pin 38 is larger than that above the pin 38. Such a pattern that the pin 38 is protruded from the mid portion of the bed 36 as viewed in the height of the bed, as in the Fig. 8 embodiment, makes its design difficult, because an imbalance of the layouts of the inner leads with respect to the suspending pin 38, and a mechanical strength of the inner leads thus laid out must be taken into account.

To cope with the problem, in the instant embodiment, the suspending pin 38 is protruded from a portion of the bed 36 that is shifted upwardly from the mid portion so that the upper and lower inner leads layouts are well balanced with respect to the suspending pin 38.

As seen from the foregoing description, in the first to 6th embodiments, the inner leads for the power voltage Vcc and ground voltage Vss are each configured to have a larger area or to consist of two inner leads. These features successfully reduces the power noise generated in the power voltage paths, with a consequent elimination of an improper operation of the internal circuit.

Further, it is noted that in the above-mentioned embodiments, the other inner leads than those 32A, 32B and 32C are laid out symmetrically with respect to the suspending pin 38. The above pattern of the inner leads reduces cost to design dies by which a lead frame of a metal foil is punched to form such a pattern.

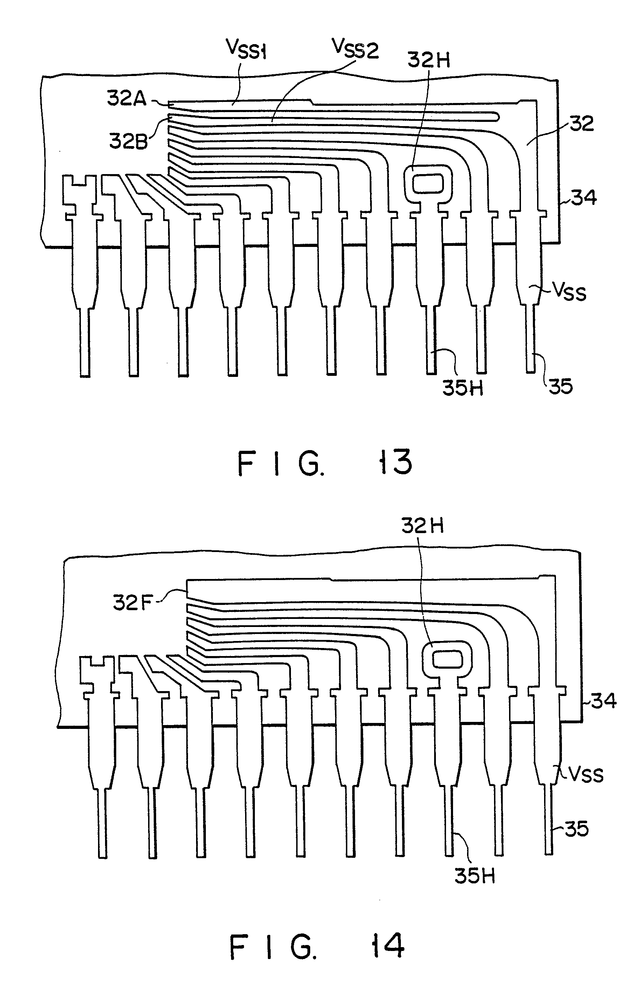

A 7th embodiment of a semiconductor integrated circuit according to the present invention is shown in Fig. 13. In the figure, a pattern of lead frames for the ground voltages Vss1 and Vss2 and those for signal input/output is illustrated. A cavity 34 contains a memory IC chip with two pad electrodes (20, 21) for Vss1 and Vss2 supply (not shown), as in the embodiment of Fig. 6. Reference numeral 32 designates inner leads and numeral 3 outer leads respectively continuous to the inner leads 32. The portions of the outer leads 35 extending outside the cavity 34 are properly bent and are to be used as external terminals of the DIP type, as in the previous case.

The inner lead of the lead frame, which is for the ground- voltage Vss supply, is branched into two leads 32A and 32B in a portion closer to one side of the cavity 34. The inner lead 32A is electrically connected at one end to one of the electrode contacts by a bonding wire (not shown). The inner lead 32B is also electrically connected at one end to the other contact by means of another bonding wire (not shown).

It is noted here that one lead frame is provided not connecting to any of electrode pads on the chip. In the figure, this lead frame consists of a circled dummy inner lead 32H and an outer lead 35H. The dummy inner lead 32H is located closer to another side of the cavity 34, and does not extend up to the chip within the cavity 34.

Let us consider a situation that, with the above connections in the semiconductor IC package, a large current flows in a peripheral circuit 23 containing the output buffer 17 (see Fig. 1), and the ground voltage Vss2 at the pad electrode 21 instantaneously rises to approximately 1 V. In this situation, the variation in the ground voltage Vss2 is transferred to the inner lead 32B. It is noted here that the pad electrode 20 coupled with the internal circuit 22 is connected to the outer lead 35 (Fig. 1) through the individual bonding wire 33 and the inner lead 32A which is branched from the inner lead 32A. The connections with the branched inner leads and the individual bonding wire, impedes the transfer of the Vss2 variation on the inner lead 32B to the inner lead 32A connecting to the internal circuit 22. Therefore, the ground voltage Vss2 is stable irrespective of the current variation in the output buffer. The proper operation of the internal circuit 22 is always ensured. The connections using the branched inner leads is advantageous particularly in the recent high speed memory devices, because these require the flow of simultaneous large current into the output buffer. In the high speed memory devices using the above connections, the internal circuit is insensitive to the power noise.

Further, the instant embodiment uses the dummy inner lead 32H that is located in the end portion of the cavity 34, while failing to reach the chip located in the central portion of the cavity. With the provision of the dummy inner leads 32H, a more design freedom can be obtained when the inner leads 32A and 32B are designed. If required, larger areas can be secured for these inner leads 32A and 32B.

An 8th embodiment of a semiconductor integrated circuit according to the present invention, is illustrated in Fig. 14. The figure shows a pattern of lead frames for the ground voltage Vss and those for signal input/output. The 8th embodiment is featured in that a single wide inner lead 32F is used for the ground voltage Vss supply, in place of the inner leads 32A and 32B (Fig. 10). An inner lead for the Vcc supply is wider than the other inner leads, as in the second embodiment of Fig. 10.

Also in this embodiment, a dummy lead frame is provided not connecting to any of electrode pads on the chip. As shown, this lead frame consists of a circled dummy inner lead 32H and an outer lead 35H. The dummy inner lead 32H is located closer to another side of the cavity 34, and does not extend up to the chip within the cavity 34.

The feature of provision of the wider inner lead 32F for the ground voltage path restricts the power noise generated in this path, hence eliminating the improper operation of the internal circuit.

Another feature of providing the dummy inner lead 32H located in the end portion of the cavity increases a design freedom in designing the wider inner lead 32F.

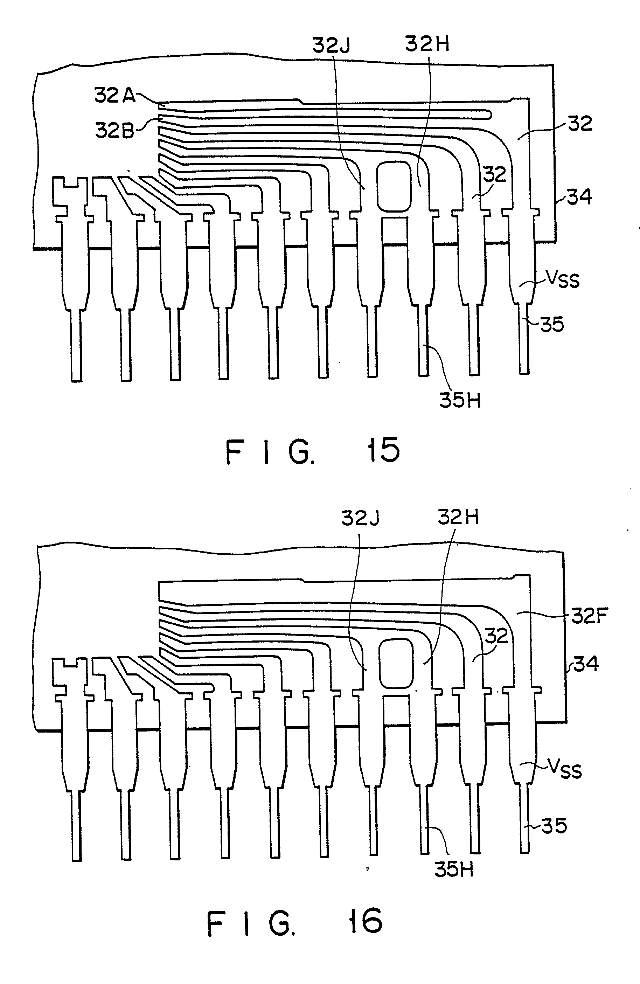

A 9th embodiment of a semiconductor integrated circuit according to the present invention is shown in Fig. 15. In the figure, a pattern of lead frames for the ground voltages Vss1 and Vss2 and those for signal input/output is illustrated. The inner lead of the lead frame, which is for the ground voltage Vss supply, is branched into two leads 32A and 32B in a portion closer to one side of the cavity 34. A dummy inner lead 32H is also provided. This dummy inner lead is coupled with another lead frame 32J for signal input/output that is located adjacent to the dummy inner lead 32H. These lead frames are coupled with each other in a portion closer to one side of the cavity 34. The coupling of these lead frames reenforces the inner lead frame 32J for signal input/output.

A 10th embodiment of a semiconductor integrated circuit according to the present invention is shown in Fig. 16. The inner lead of the lead frame, which is for the ground voltage Vss supply, is wider than other lead frames. A dummy inner lead 32H is also provided. This dummy inner lead is coupled with another lead from 32J for signal input/output that is located adjacent to the dummy inner lead 32H. These lead frames are coupled with each other in a portion closer to one side of the cavity 34. The coupling of these lead frames reenforces the inner lead frame 32J for signal input/output.

As seen from the foregoing description, the embodiments of Figs. 13 to 16 as mentioned above are each provided with the dummy inner lead 32H. The dummy inner lead 32H is formed near the end portion of the cavity, and does not reach the chip located in the central part of the cavity. This feature enables a designer to design the inner lead for the ground voltage supply having a larger area more flexibly.

As seen from the foregoing description, the present invention has succeeded in solving the problems of the prior art, the large power noise in the power voltage supply path and the improper operation of the internal circuit due to the power noise.

## Claims

1. A semiconductor integrated circuit comprising:
a semiconductor chip (31) having a plurality of pad electrodes (20, 21) on a major surface thereof;
a housing (34) for housing said semiconductor chip;
a plurality of lead frames (32, 35) each being made up of an inner lead (32) and an outer lead (35);
metal wires (33) each for electrically connecting the tip of each said inner lead to one pad electrode; and
one of said plurality of lead frames whose inner lead (32) is branched into a plurality of leads (32A, 32B), said lead frame supplying a power voltage.

2. The semiconductor integrated circuit according to claim 1, characterized in that said lead frame for power voltage supply supplies a lower power voltage to said semiconductor chip.

3. The semiconductor integrated circuit according to claim 2, characterized in that said power voltage supply is a lead frame for supplying a lower power voltage to said semiconductor chip, said lead frame containing an inner lead being branched into two leads (32A, 32B) in an end portion of said housing (34).

4. The semiconductor integrated circuit according to claim 3, characterized in that the inner lead of said lead frame for power voltage supply is branched into two leads (32A, 32B) in an end portion of said housing (34).

5. The semiconductor integrated circuit according to claim 3, characterized by further comprising a pin (40) formed integral with said two leads (32A, 32B), said pin reenforcing said leads (32A, 32B).

6. The semiconductor integrated circuit according to claim 1, characterized by further comprising a bed (36) on which said semiconductor chip is placed, and a pair of pins (37, 38) for supporting said bed, said pins (37, 38) being coupled with the opposite sides of said housing (34).

7. The semiconductor integrated circuit according to claim 6, characterized in that one of said inner pins is coupled with one of said pair of pins (37, 38).

8. The semiconductor integrated circuit according to claim 7, characterized in that the other of said pair of pins (37, 38) is further connected to an inner lead (32G) for supplying a power voltage.

9. The semiconductor integrated circuit according to claim 1, characterized by further comprising a dummy lead frame (32H, 35H) not electrically connecting to a pad electrode on said chip (31).

10. The semiconductor integrated circuit according to claim 9, characterized in that the inner lead (32H) of said dummy lead frame is located near an end portion of said housing (34).

11. The semiconductor integrated circuit according to claim 10, characterized in that the inner lead (32H) of said dummy lead frame (32H, 35H) is coupled with the inner lead (32J) of another lead frame.

12. The semiconductor integrated circuit according to claim 6, characterized in that said pair of pins (37, 38) are coupled with the opposite sides of said housing (34) at different positions.

13. A semiconductor integrated circuit comprising:
a semiconductor chip (31) having a plurality of pad electrodes (20, 21) on a major surface thereof;
a housing (34) for housing said semiconductor chip;
a plurality of lead frames (32, 35) each being made up of an inner lead (32) and an outer lead (35);
metal wires (33) each for electrically connecting the tip of each said inner lead to one pad electrode; and
one of said plurality of lead frames (32, 35) whose inner lead (32C, 32F) has a larger area than those of the other lead frames, said lead frame supplying a power voltage.

14. The semiconductor integrated circuit according to claim 13, characterized in that said lead frame (32C, 3) for power voltage supply supplies a higher power voltage to said semiconductor chip.

15. The semiconductor integrated circuit according to claim 13, characterized in that said lead frame (32F, 35) for power voltage supply supplies a lower power voltage to said semiconductor chip.

16. The semiconductor integrated circuit according to claim 14, characterized by further comprising a pin (40) formed integral with said inner leads (32C), said pin reenforcing said inner lead (32C).

17. The semiconductor integrated circuit according to claim 15, characterized by further comprising a pin (40) formed integral with said inner leads (32F), said pin reenforcing said inner lead (32F).

F I G. 1

F I G. 2

F I G. 3

F I G. 4

F I G. 5

F I G.  6

F I G.  7

F I G. 8

F I G. 9

F I G. 10

F I G. 11

F I G. 12

F I G. 13

F I G. 14

F I G.   15

F I G.   16